# FASCICULE DE BREVET EUROPEEN

(11) **EP 3 591 496 B1**
(45) Date de publication et mention de la délivrance du brevet: **09.04.2025**
(21) Numéro de dépôt: 19182268.3
(22) Date de dépôt: 25.06.2019
(51) Int. Cl.: G06F 1/16, G06F 3/041, B60W 50/08

(54) **DISPOSITIF DE VISUALISATION À ÉCRAN TACTILE COMPORTANT UN ACCROCHE-DOIGTS**
ANZEIGEVORRICHTUNG MIT BERÜHRUNGSBILDSCHIRM, DER EINE FINGERHALTERUNG UMFASST
VIEWING DEVICE WITH TOUCH SCREEN INCLUDING A FINGER GRIP

(30) Priorité: 05.07.2018 FR 1800715
(43) Date de publication de la demande: 08.01.2020
(73) Titulaire: Thales, 92190 Meudon (FR)
(72) Inventeur: CAILLAUD, Maxime, 33700 MERIGNAC (FR); MOZER, Laurent, 33700 MERIGNAC (FR); LE ROUX, Yannick, 33700 MERIGNAC (FR)
(74) Mandataire: Atout PI Laplace

(56) Documents cités:
- WO-A1-01/00435
- US-A1- 2013 087 442
- ANDY COCKBURN ET AL: "Turbulent Touch", PROCEEDINGS OF THE 2017 CHI CONFERENCE ON HUMAN FACTORS IN COMPUTING SYSTEMS , CHI '17, ACM PRESS, NEW YORK, NEW YORK, USA, 2 May 2017 (2017-05-02), pages 6742 - 6753, XP058337656, ISBN: 978-1-4503-4655-9, DOI: 10.1145/3025453.3025584

## Description

Le domaine de l'invention est celui des écrans tactiles montés sur des tableaux de bord ou des planches de bord de véhicules. Plus spécifiquement, le domaine privilégié de l'invention est celui du transport aérien et des écrans tactiles montés sur les planches de bord des aéronefs.

En aéronautique, les planches de bord sont de plus en plus souvent munies d'écrans de visualisation comportant des surfaces tactiles permettant d'interagir de façon simple et ergonomique avec les fonctions affichées. L'utilisation de ces écrans tactiles doit pouvoir se faire dans des conditions de vibrations importantes dues, par exemple, aux turbulences atmosphériques ou, pour les aéronefs militaires, à des phases particulières de manœuvre ou de combat. D'autres types de véhicules rencontrent des problèmes du même ordre comme, par exemple, les véhicules tout-terrain qui peuvent être soumis à des vibrations ou des accélérations importantes. Ces conditions ressenties par l'utilisateur entravent en partie sa capacité à interagir de façon précise avec l'écran tactile, pouvant entraîner des interactions involontaires avec l'écran.

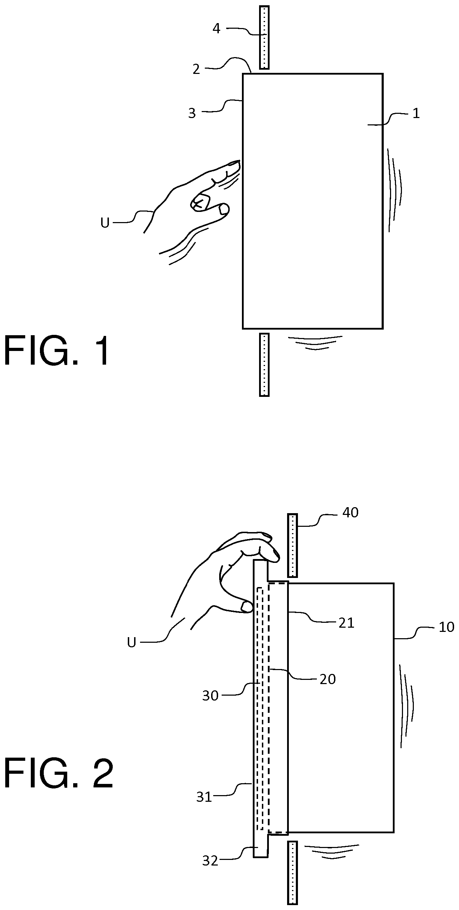

La figure 1 illustre ce problème. Elle représente un dispositif de visualisation 1 comportant sur sa face avant 2 une surface tactile 3. Il est monté sur une planche de bord 4. Lorsque celle-ci est soumise, par exemple, à des vibrations, la main de l'utilisateur U n'a aucune prise sur l'écran tactile et la précision du geste se dégrade fortement. Les effets des perturbations sont d'autant plus significatifs que l'écran se trouve à une certaine distance de l'utilisateur, lui imposant de tendre le bras pour pouvoir réaliser l'action, ce qui augmente encore l'imprécision du geste.

Ce problème est récent. Dans le passé, les moyens de contrôle et d'interaction étaient essentiellement des postes de commande comportant des boutons physiques tels que des boutons poussoirs ou des boutons rotatifs qui permettaient une prise en main correcte par l'utilisateur avant d'engager l'action. L'introduction de dispositifs de visualisation a permis de réduire considérablement le nombre d'équipements dans un poste de pilotage, de diminuer ainsi le poids et l'encombrement et d'améliorer l'ergonomie de la présentation d'informations. Ces dispositifs de visualisation ont initialement été contrôlés par des dispositifs de pointage graphique du type « souris informatique » ou « CCD », acronyme de « Cursor Control Device ». Ces dispositifs de pointage présentent les mêmes avantages que les postes de commande. On peut facilement stabiliser la main, par exemple, sur un « repose-paume » et positionner correctement le pointeur graphique sur l'écran de visualisation.

Le remplacement des dispositifs de pointage graphique par des surfaces tactiles a plusieurs avantages. Il permet d'avoir une interaction directe et rapide avec, par exemple, un menu affiché. Il ouvre la possibilité à de nouvelles fonctions réalisées, par exemple, par des mouvements coordonnés d'un doigt ou de plusieurs doigts comme les fonctions « Zoom ». Néanmoins, l'interaction directe sur un écran réduit la possibilité de stabilisation qu'offre un moyen physique traditionnel tel qu'un bouton de commande ou un dispositif de pointage et peut générer de la fatigue musculaire, compte-tenu de la distance de l'utilisateur à l'écran.

Pour résoudre ce problème, différentes solutions techniques ont été proposées. Le brevet US 9 348 446 intitulé « Bezel for vehicular touchscreen displays » propose d'ajouter, sur les côtés de l'écran, un repose-paume incurvé et amovible réalisé dans deux matières différentes. Cette solution cherche à privilégier l'adhérence de façon à stabiliser la paume de la main de l'utilisateur.

Le brevet US 9 870 093 intitulé « System and method for improving touch screen display use under vibration and turbulence » décrit un écran de visualisation comportant un entourage en élastomère souple permettant, là encore, de faciliter la préhension et l'adhérence.

La demande US 2017/0 075 442 intitulée « Touch screen bezel design for use in aviation operations » décrit un écran de visualisation comportant un entourage dont les surfaces d'appui comportent des protubérances permettant d'augmenter l'adhérence.

La demande WO01/00435 intitulée "Device for fixing instruments on an instrument panel" décrit un dispositif de fixation d'un instrument, tel qu'un afficheur à écran à cristaux liquides, sur une planche de bord avec des renfoncements. Enfin, la demande US 2012/0 105 335 intitulée « Touch screen display assembly » décrit un écran de visualisation comportant, là encore, un entourage comprenant des surfaces d'appui dont les matières et les formes ont été travaillées de façon à en augmenter l'adhérence.

Toutes ces solutions techniques présentent un certain nombre d'inconvénients. Elles reposent essentiellement sur l'augmentation de l'adhérence lorsque la paume ou les doigts de l'utilisateur sont en contact avec le pourtour de l'écran. Cette augmentation est obtenue soit en jouant sur les matières, soit en modifiant les formes des surfaces d'appui, soit en ajoutant des protubérances de formes diverses sur les surfaces d'appui. Cette adhérence peut se montrer insuffisante lorsque les turbulences sont importantes ou lorsque l'utilisateur porte des gants. Les surfaces d'appui, pour être efficaces, ont nécessairement des dimensions importantes et peuvent ainsi masquer d'autres instruments. Par ailleurs, l'industrialisation de certaines surfaces d'appui constituées de matériaux hybrides peut se montrer complexe à mettre en œuvre et coûteuses. Les matières molles peuvent se dégrader dans le temps, perdant ainsi une partie de leur efficacité. Enfin, ces solutions techniques ne permettent pas d'identifier facilement la position de la main en aveugle, rendant difficile tout pré-positionnement.

Le dispositif de visualisation selon l'invention ne présente pas les inconvénients précédents. Il est simple, peu coûteux, facile à mettre en œuvre et efficace. Le dispositif selon l'invention comporte une surface tactile dont le cadre comporte, sur son pourtour, un collet rigide utilisé comme « accroche-doigts ». Il a été testé avec succès en conditions expérimentales. Il a été, en particulier, démontré que la stabilité, lors de turbulences, est meilleure si l'utilisateur peut accrocher les doigts au niveau de l'écran de façon que la main se trouve en traction. Dans ce cas, la traction est exercée par l'index accompagné du majeur et de l'annulaire, le pouce assurant l'action sur la dalle tactile. Le simple exercice d'une pression sur le bord de l'écran n'assure pas le même niveau de stabilité. Ainsi, les formes les plus ergonomiques des accroche-doigts ont pu être déterminées.

Par ailleurs, l'industrialisation des accroche-doigts selon l'invention est facile à mettre en œuvre dans la mesure où les pièces sont simples à usiner. De plus, il est facile de modifier un cadre existant de visualisation par ajout des accroche-doigts selon l'invention.

Plus précisément, l'invention a pour objet un dispositif de visualisation tel que revendiqué dans la revendication 1.

Avantageusement, le cadre comporte une pluralité de repères disposés sur au moins un côté du pourtour du cadre, lesdits repères étant séparés d'une distance constante.

Avantageusement, le cadre comporte une pluralité de repères disposés sur au moins un côté du pourtour du cadre, lesdits repères étant séparés d'une distance variable.

L'invention concerne également un dispositif de visualisation tel que revendiqué dans la revendication 4.

Avantageusement, le cadre comporte une pluralité d'échancrures disposées sur au moins un côté du pourtour du cadre, lesdites échancrures étant séparées d'une distance constante.

Avantageusement, le cadre comporte une pluralité d'échancrures disposées sur au moins un côté du pourtour du cadre, lesdites échancrures étant séparées d'une distance variable.

L'invention sera mieux comprise et d'autres avantages apparaîtront à la lecture de la description qui va suivre donnée à titre non limitatif et grâce aux figures annexées parmi lesquelles :
La figure 1 précédemment décrite représente un cadre de surface tactile selon l'art antérieur ;
La figure 2 représente une vue générale d'un premier mode de réalisation d'un cadre de surface tactile selon l'invention ;
La figure 3 représente une vue en coupe partielle agrandie du cadre de la figure 2 ;
La figure 4 représente une vue en perspective partielle agrandie du cadre de la figure 2 ;
La figure 5 représente une vue générale d'une variante de réalisation du cadre de surface tactile de la figure 2 ;
La figure 6 représente une vue en perspective partielle agrandie du cadre de la figure 5 ;
La figure 7 représente une vue générale d'un second mode de réalisation d'un cadre de surface tactile selon l'invention ;
La figure 8 représente une vue en perspective partielle agrandie du cadre de la figure 7.

A titre d'exemple, la figure 2 représente une vue générale d'un premier mode de réalisation d'un dispositif de visualisation comportant un cadre de surface tactile selon l'invention. Dans ce qui suit, les dispositifs de visualisation sont montés sur des planches de bord d'aéronef. Cependant, le système « accroche-doigts » selon l'invention peut être monté sur tous types de véhicules terrestres ou maritimes susceptibles d'être soumis à des accélérations ou à des vibrations importantes.

Le dispositif de visualisation 10 comporte une face avant 20 sur laquelle est montée une surface tactile 30. Le dispositif selon l'invention peut s'adapter à tous types de dispositif de visualisation et de surface tactile. Le dispositif de visualisation comporte une face d'appui 21 sur la planche de bord 40, la face avant 20 et la face d'appui 21 ayant des formes rectangulaires. La face d'appui peut comporter des moyens de fixation du dispositif de visualisation sur la planche de bord qui sont connus de l'homme du métier.

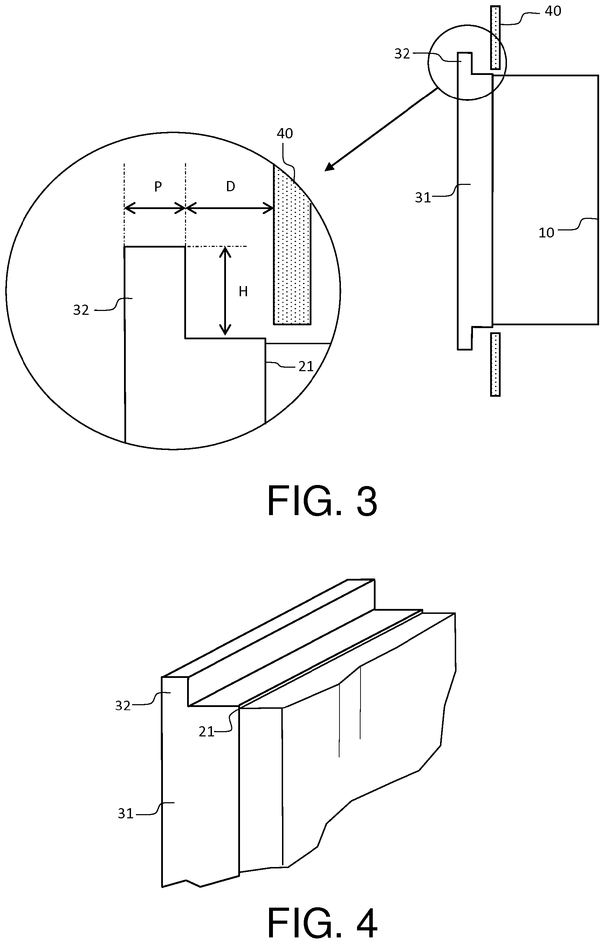

La surface tactile 30 est entourée d'un cadre rigide 31. Ce cadre est généralement métallique. Ce cadre 31 comporte, sur son pourtour, un collet 32 situé dans le prolongement de la face avant. La figure 3 représente une vue en coupe partielle agrandie du collet de la figure 2. La section de ce collet 32 dans un plan perpendiculaire à la face avant est sensiblement rectangulaire, le collet surmontant la face avant d'une hauteur H de quelques millimètres. Plus précisément, cette hauteur est égale ou supérieure à 3 millimètres. Sa profondeur P est également de quelques millimètres. Plus précisément, sa profondeur est égale ou supérieure à 3 millimètres. La distance D séparant la paroi interne de ce collet de la face d'appui est égale ou supérieure à 10 millimètres.

Ces paramètres résultent d'un optimum entre un encombrement et un poids les plus faibles possibles tout en préservant la fonction de stabilisation de la main autour de l'écran de visualisation.

Lorsque l'utilisateur U veut utiliser la surface tactile, il peut accrocher ses doigts au collet qui lui offre une prise suffisante comme on le voit sur la figure 2. L'effort en traction sur le collet est à la fois plus efficace et moins fatigant qu'en effort en appui. L'utilisateur peut ainsi utiliser la surface tactile de façon plus sûre et plus efficace.

La figure 4 représente une vue en perspective partielle agrandie du cadre 31 et du collet 32 des figures 2 et 3.

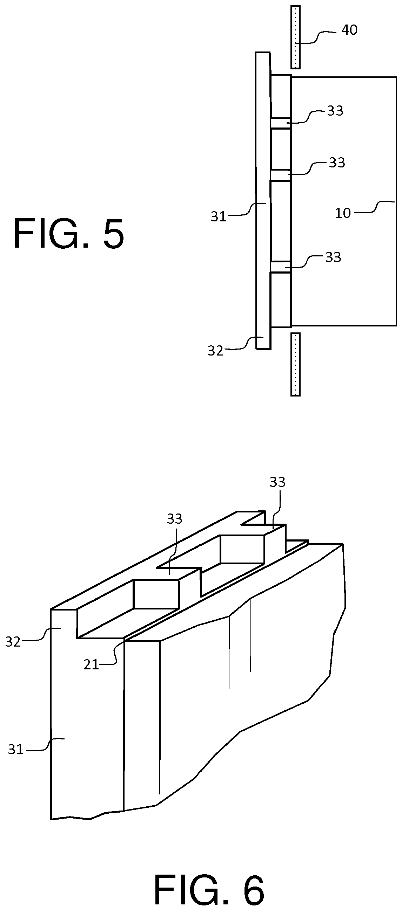

La figure 5 représente une vue générale d'une variante de réalisation du cadre de surface tactile de la figure 2. Dans cette variante, le cadre 31 comporte un ou plusieurs repères 33 disposés entre la paroi interne du collet 32 et la face d'appui 21, chaque repère 33 ayant une forme sensiblement parallélépipédique, sa hauteur étant celle du collet, sa profondeur étant égale à la distance séparant la paroi interne du collet de la face d'appui, sa largeur étant égale ou supérieure à 5 millimètres.

Ces repères ont une double utilité. Ils permettent de mieux assurer la prise des doigts de l'utilisateur. En particulier sur les parties latérales de l'écran, les repères offrent une bonne stabilisation verticale et permettent de contrer les effets de la pesanteur, empêchant ainsi la main de glisser vers le bas de l'écran. Ils permettent également de se repérer facilement sur la surface tactile. On peut les séparer d'une distance constante de façon, par exemple, à diviser le bord d'écran en zones d'égales dimensions. On peut également les placer à des positions prédéfinies correspondant à des fonctions particulières adressées par la surface tactile. Ces repères peuvent être tous identiques ou de forme différente pour mieux les identifier. Sur les figures 5 et 6, les repères sont de forme parallélépipédique mais d'autres formes sont possibles. Certaines parties peuvent être arrondies pour faciliter la préhension. De façon générale, tout changement de forme ou de dimensions de ces repères reste dans le cadre du dispositif de visualisation selon l'invention.

La figure 6 représente une vue en perspective partielle agrandie du cadre 31, du collet 32 et des repères 33 de la figure 5.

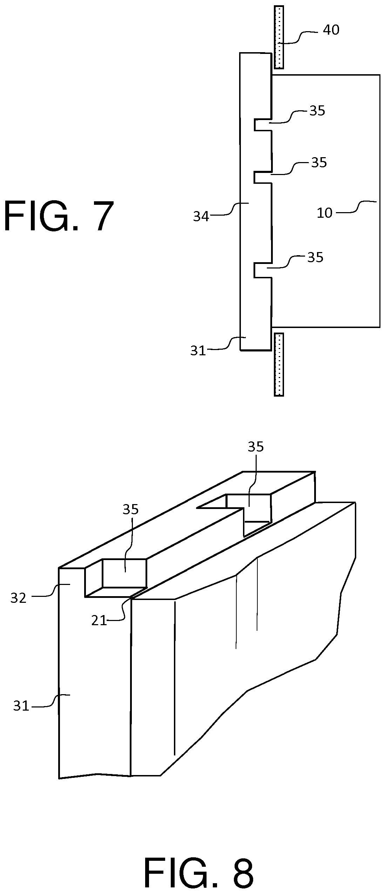

La figure 7 représente un second mode de réalisation du collet des figures précédentes. Dans ce mode de réalisation, le cadre 31 comporte, sur son pourtour, un collet 34 situé dans le prolongement de la face avant, la section de ce collet dans un plan perpendiculaire à la face avant étant rectangulaire, le collet surmontant la face avant d'une hauteur égale ou supérieure à 3 millimètres, sa profondeur étant égale à la distance séparant la paroi interne de ce collet de la face d'appui. Le collet 34 comporte des échancrures 35 ayant une forme sensiblement parallélépipédique. La profondeur de l'échancrure est de quelques millimètres et préférentiellement, elle est égale ou supérieure à 3 millimètres, sa longueur étant égale à la distance séparant la paroi interne du collet de la face d'appui, sa largeur est de quelques millimètres et préférentiellement, cette largeur est égale ou supérieure à 5 millimètres.

La figure 8 représente une vue en perspective partielle agrandie du cadre 31, du collet 32 et des échancrures 35 de la figure 7.

Là encore, ces échancrures ont une double utilité. Elles permettent de mieux assurer la prise des doigts de l'utilisateur. En particulier sur les parties latérales de l'écran, les échancrures offrent une bonne stabilisation verticale et permettent de contrer les effets de la pesanteur, empêchant ainsi la main de glisser vers le bas de l'écran. Elles permettent également de se repérer facilement sur la surface tactile. Ainsi, on peut les séparer d'une distance constante de façon, par exemple, à diviser le bord d'écran en zones d'égales dimensions. On peut également les placer à des positions prédéfinies correspondant à des fonctions particulières adressées par la surface tactile. Ces échancrures peuvent être toutes identiques ou de forme différente pour mieux les identifier. Sur les figures 7 et 8, les échancrures sont de forme parallélépipédique mais d'autres formes sont possibles. Certaines parties peuvent être arrondies pour faciliter la préhension. De façon générale, tout changement de forme ou de dimensions de ces échancrures reste dans le cadre du dispositif de visualisation selon l'invention.

Les avantages principaux des « accroche-doigts » selon l'invention sont qu'ils sont simples à usiner, ne nécessitent que des changements simples de la forme du cadre et sont pratiquement inusables. Par ailleurs, ils introduisent très peu de masques visuels dans la mesure où un rebord de quelques millimètres suffit à assurer une prise correcte de l'utilisateur.

De plus, dans un système comportant plusieurs écrans de visualisation similaires, la forme des accroche-doigts ne dépend pas de la position de l'écran. On peut réaliser un échange d'écrans en cas de panne. On limite ainsi les coûts de production.

Un dernier avantage est que cette solution d'accroche-doigts permet une liberté de mouvement de la main le long du dispositif de visualisation, tout en conservant la stabilisation recherchée.

## Revendications

1. Dispositif de visualisation (10) destiné à être monté sur une planche de bord, ledit dispositif de visualisation comportant une face avant (20) sur laquelle est montée une surface tactile (30) et une face d'appui (21) sur la planche de bord, la face avant et la face d'appui ayant des formes rectangulaires, la surface tactile étant entourée d'un cadre rigide (31), **caractérisé en ce que** ce cadre comporte, sur son pourtour, un collet (32), configuré pour accrocher les doigts d'un utilisateur au niveau de l'écran de sorte que sa main se trouve en traction, situé dans le prolongement de la face avant, la section de ce collet dans un plan perpendiculaire à la face avant étant rectangulaire, le collet surmontant la face avant d'une hauteur égale ou supérieure à 3 millimètres, sa profondeur étant égale ou supérieure à 3 millimètres et la distance séparant la paroi interne de ce collet de la face d'appui étant égale ou supérieure à 10 millimètres,
le cadre comportant au moins un repère, consistant en une excroissance (33), disposé entre la paroi interne du collet et la face d'appui, ledit repère ayant une forme sensiblement parallélépipédique, sa hauteur étant celle du collet, sa profondeur étant égale à la distance séparant la paroi interne du collet de la face d'appui, sa largeur étant égale ou supérieure à 5 millimètres.

2. Dispositif de visualisation selon la revendication 1, **caractérisé en ce que** le cadre comporte une pluralité d'excroissances (33) disposés sur au moins un côté du pourtour du cadre, lesdits repères étant séparés d'une distance constante.

3. Dispositif de visualisation selon la revendication 1, **caractérisé en ce que** le cadre comporte une pluralité d'excroissances (33) disposés sur au moins un côté du pourtour du cadre, lesdits repères étant séparés d'une distance variable.

4. Dispositif de visualisation (10) destiné à être monté sur une planche de bord, ledit dispositif de visualisation comportant une face avant (20) sur laquelle est montée une surface tactile (30) et une face d'appui (21) sur la planche de bord, la face avant et la face d'appui ayant des formes rectangulaires de mêmes dimensions, la surface tactile étant entourée d'un cadre rigide (31), **caractérisé en ce que** ce cadre comporte, sur son pourtour, un collet (32), configuré pour accrocher les doigts d'un utilisateur au niveau de l'écran de sorte que sa main se trouve en traction, situé dans le prolongement de la face avant, la section de ce collet dans un plan perpendiculaire à la face avant étant rectangulaire, le collet surmontant la face avant d'une hauteur égale ou supérieure à 3 millimètres, sa profondeur étant égale à la distance séparant la paroi interne de ce collet de la face d'appui, ledit collet comportant au moins un repère, consistant en une échancrure (35) ayant une forme sensiblement parallélépipédique, sa profondeur étant égale ou supérieure à 3 millimètres, sa longueur étant égale à la distance séparant la paroi interne du collet de la face d'appui, sa largeur étant égale ou supérieure à 5 millimètres.

5. Dispositif de visualisation selon la revendication 4, **caractérisé en ce que** le cadre comporte une pluralité d'échancrures (35) disposées sur au moins un côté du pourtour du cadre, lesdites échancrures étant séparées d'une distance constante.

6. Dispositif de visualisation selon la revendication 4, **caractérisé en ce que** le cadre comporte une pluralité d'échancrures (35) disposées sur au moins un côté du pourtour du cadre, lesdites échancrures étant séparées d'une distance variable.

## Patentansprüche

1. Anzeigevorrichtung (10), die dazu vorgesehen ist, auf einem Armaturenbrett montiert zu werden, wobei die Anzeigevorrichtung eine Vorderfläche (20), auf der eine Berührungsfläche (30) montiert ist, und eine Auflagefläche (21) auf dem Armaturenbrett aufweist, wobei die Vorderfläche und die Auflagefläche rechteckige Formen aufweisen, wobei die Berührungsfläche von einem starren Rahmen (31) umgeben ist, **dadurch gekennzeichnet, dass** dieser Rahmen auf seinem Umfang einen Kragen (32) aufweist, konfiguriert, um die Finger eines Benutzers so an den Bildschirm zu haften, dass seine Hand unter Zugkraft steht, der sich in der Verlängerung der Vorderfläche befindet, wobei der Abschnitt dieses Kragens in einer Ebene senkrecht zur Vorderfläche rechteckig ist, wobei der Kragen die Vorderfläche um eine Höhe gleich oder größer als 3 Millimeter überragt, wobei dessen Tiefe gleich oder größer als 3 Millimeter ist und der Abstand, der die Innenwand dieses Kragens von der Auflagefläche trennt, gleich oder größer als 10 Millimeter beträgt,
wobei der Rahmen mindestens einen Bezugspunkt aufweist, der aus einem Vorsprung (33) besteht, der zwischen der Innenwand des Kragens und der Auflagefläche angeordnet ist, wobei der Bezugspunkt im Wesentlichen eine Parallelepipedform aufweist, wobei dessen Höhe derjenigen des Kragens entspricht, wobei dessen Tiefe gleich dem Abstand ist, der die Innenwand des Kragens von der Auflagefläche trennt, wobei dessen Breite gleich oder größer als 5 Millimeter ist.

2. Anzeigevorrichtung nach Anspruch 1, **dadurch gekennzeichnet, dass** der Rahmen eine Vielzahl von Vorsprüngen (33) aufweist, die auf mindestens einer Seite des Umfangs des Rahmens angeordnet ist, wobei die Bezugspunkte um einen konstanten Abstand getrennt sind.

3. Anzeigevorrichtung nach Anspruch 1, **dadurch gekennzeichnet, dass** der Rahmen eine Vielzahl von Vorsprüngen (33) aufweist, die auf mindestens einer Seite des Umfangs des Rahmens angeordnet ist, wobei die Bezugspunkte um einen variablen Abstand getrennt sind.

4. Anzeigevorrichtung (10), die dazu vorgesehen ist, auf einem Armaturenbrett montiert zu werden, wobei die Anzeigevorrichtung eine Vorderfläche (20), auf der eine Berührungsfläche (30) montiert ist, und eine Auflagefläche (21) auf dem Armaturenbrett aufweist, wobei die Vorderfläche und die Auflagefläche rechteckige Formen mit den gleichen Abmessungen aufweisen, wobei die Berührungsfläche von einem starren Rahmen (31) umgeben ist, **dadurch gekennzeichnet, dass** dieser Rahmen auf seinem Umfang einen Kragen (32) aufweist, konfiguriert, um die Finger eines Benutzers so an den Bildschirm zu haften, dass seine Hand unter Zugkraft steht, der sich in der Verlängerung der Vorderfläche befindet, wobei der Abschnitt dieses Kragens in einer Ebene senkrecht zur Vorderfläche rechteckig ist, wobei der Kragen die Vorderfläche um eine Höhe gleich oder größer als 3 Millimeter überragt, wobei dessen Tiefe gleich dem Abstand ist, der die Innenwand dieses Kragens von der Auflagefläche trennt, wobei der Kragen mindestens einen Bezugspunkt aufweist, der aus einer Kerbe (35) mit im Wesentlichen einer Parallelepipedform besteht, wobei dessen Tiefe gleich oder größer als 3 Millimeter ist, wobei dessen Länge gleich dem Abstand ist, der die Innenwand des Kragens von der Auflagefläche trennt, wobei seine Breite gleich oder größer als 5 Millimeter ist.

5. Anzeigevorrichtung nach Anspruch 4, **dadurch gekennzeichnet, dass** der Rahmen eine Vielzahl von Kerben (35) aufweist, die auf mindestens einer Seite des Umfangs des Rahmens angeordnet ist, wobei die Kerben um einen konstanten Abstand getrennt sind.

6. Anzeigevorrichtung nach Anspruch 4, **dadurch gekennzeichnet, dass** der Rahmen eine Vielzahl von Kerben (35) aufweist, die auf mindestens einer Seite des Umfangs des Rahmens angeordnet ist, wobei die Kerben um einen variablen Abstand getrennt sind.

## Claims

1. A display device (10) intended to be mounted on an instrument panel, said display device having a front face (20) on which is mounted a touch surface (30) and a bearing face (21) bearing on the instrument panel, the front face and the bearing face having rectangular forms, the touch surface being surrounded by a rigid frame (31), **characterised in that** this frame has, on its perimeter, a flange (32), configured for a user's fingers to grip the screen, so that his hand is in traction, situated in the extension of the front face, the section of this flange in a plane perpendicular to the front face being rectangular, the flange topping the front face by a height equal to or greater than 3 millimeters, its depth being equal to or greater than 3 millimeters and the distance separating the internal wall of this flange from the bearing face being equal to or greater than 10 millimeters,
the frame having at least one point of reference, consisting of a protrusion (33) arranged between the internal wall of the flange and the bearing face, said point of reference having a substantially parallelepipedal form, its height being that of the flange, its depth being equal to the distance separating the internal wall of the flange from the bearing face, its width being equal to or greater than 5 millimeters.

2. The display device according to claim 1, **characterised in that** the frame has a plurality of protrusions (33) arranged on at least one side of the perimeter of the frame, said points of reference being separated by a constant distance.

3. The display device according to claim 1, **characterised in that** the frame has a plurality of protrusions (33), arranged on at least one side of the perimeter of the frame, said points of reference being separated by a variable distance.

4. The display device (10) intended to be mounted on an instrument panel, said display device having a front face (20) on which is mounted a touch surface (30) and a bearing face (21) bearing on the instrument panel, the front face and the bearing face having rectangular forms of the same dimensions, the touch surface being surrounded by a rigid frame (31), **characterised in that** this frame comprises, on its perimeter, a flange (32), configured for a user's fingers to grip the screen, so that his hand is in traction, situated in the extension of the front face, the section of this flange in a plane perpendicular to the front face being rectangular, the flange topping the front face by a height equal to or greater than 3 millimeters, its depth being equal to the distance separating the internal wall of this flange from the bearing face, said flange comprising at least one point of reference, consisting of a notch (35) having a substantially parallelepipedal form, its depth being equal to or greater than 3 millimeters, its length being equal to the distance separating the internal wall of the flange from the bearing face, its width being equal to or greater than 5 millimeters.

5. The display device according to claim 4, **characterised in that** the frame has a plurality of notches (35), arranged on at least one side of the perimeter of the frame, said notches being separated by a constant distance.

6. The display device according to claim 4, **characterised in that** the frame comprises a plurality of notches (35) arranged on at least one side of the perimeter of the frame, said notches being separated by a variable distance.
